# EUROPEAN PATENT SPECIFICATION

(11) **EP 2 016 671 B1**
(45) Date of publication and mention of the grant of the patent: **02.07.2014**
(21) Application number: 07732560.3
(22) Date of filing: 25.04.2007
(51) Int. Cl.: H03D 9/06

(54) **RADIATION DETECTOR**
STRAHLUNGSDETEKTOR
DETECTEUR DE RADIATION

(30) Priority: 25.04.2006 US 794732 P; 29.07.2006 GB 0615140
(43) Date of publication of application: 21.01.2009
(73) Proprietor: Digital Barriers Services Limited, London SE1 9PG (GB)
(72) Inventor: MANN, Christopher, Mark, Cornwall TR8 4ET (GB); COOMBS, David, John, Oxfordshire OX28 5FL (GB)
(74) Representative: Arrowsmith, Peter Michael E.
(86) International application number: PCT/GB2007/001523
(87) International publication number: WO 2007/125326

(56) References cited:
- WO-A-97/30488
- WO-A-2004/038854
- WO-A-2005/038975
- US-A- 5 062 149

## Description

The present invention relates to a radiation detector for use in detecting objects using the electromagnetic spectrum at wavelengths in the centimetre to sub-millimetre range.

Embodiments of the invention are relevant from the microwave to the terahertz region of the electromagnetic spectrum. However, the terahertz region has particular benefit for many applications in offering high resolution in small systems and specific embodiments of the invention are described below which operate in the terahertz region. "Terahertz" in this context means the electromagnetic spectrum at wavelengths in the millimetre to sub-millimetre range.

Arrangements using a local oscillator include for example super heterodyne, heterodyne, homodyne or direct IF ("intermediate frequency") detection and the use of direct amplification for detection where the amplifier is configured as a regenerative or self oscillating mixer. Embodiments of the invention are particularly suitable for use with superheterodyne and heterodyne harmonic mixers and even more so with balanced harmonic mixers such as subharmonic mixers.

(In heterodyne detection at wavelengths in the centimetre to sub-millimetre range, the local oscillator is frequency-shifted with respect to the incoming signal to be detected while in homodyne detection it has the same frequency.)

The range mentioned above is referred to herein generally as the terahertz spectrum. Terahertz radiation has been found a useful tool for imaging and other purposes because some materials are transparent to it which are opaque through the visible spectrum. This allows these materials to be "seen through" using terahertz radiation where they could not using visible optical radiation. For example, terahertz wavelengths have been used in imaging the earth's surface through the atmosphere and for improving visibility in bad weather (for example for flying or driving). Some materials can be distinguished under terahertz radiation because of their distinctive transmissivity or reflectivity and this has been used for example in detecting food or chemical components. Further, objects themselves can emit terahertz radiation, including the human body. This has been used for example in medicine for detecting skin cancer. Because clothing is generally transparent to terahertz radiation but weaponry is not, another application has been the detection of weaponry otherwise concealed about the person.

Cameras for imaging an object by use of the terahertz ("THz") spectrum are known. For example, an arrangement is described in International Patent Application WO 2004038854 in the name Agence Spatiale Européenne. In this arrangement, the camera is based on a double bank of horn antennae which each pick up terahertz radiation, in use, which is directed into a mixer channel to extract an intermediate frequency signal using a local oscillator. This known heterodyne technique allows smaller detectors to be used at room temperature in the terahertz range than might otherwise be necessary and so supports fmer resolution.

The detectors of WO 2004038854 are constructed using a pair of substrates, at least one of which is patterned to accommodate, for each detector, the antenna, a mixer channel and a via through the substrate to a signal output. A waveguide structure is coupled to the mixer channel to deliver a signal from the local oscillator. In the finished camera, the two substrates lie face to face in a sandwich arrangement so that the patterning accommodating the detector construction is between the substrates and protected thereby.

US patent number 5062149 assigned to General Dynamics Corporation discloses a millimetre wave device having a multi-layered substrate-based construction with apertures therethrough.

According to embodiments of the present invention, there is provided an electromagnetic radiation detector comprising:
i) at least one substrate;
ii) a radio frequency input for receiving radio frequency signals to be detected;
iii) a local oscillator input for receiving a local oscillator signal;
iv) a mixer supported by the substrate and coupled to the radio frequency input and the local oscillator input for use in generating an intermediate frequency signal by mixing a received radio frequency signal with the local oscillator signal; and
v) a filter channel for use in controlling passage of radio frequency signals in the detector and in extracting the intermediate frequency signal,
wherein the substrate is provided with an aperture having an axial direction which extends into the substrate, characterised in that the aperture accommodates an intermediate frequency extraction section of the filter channel for extracting the intermediate frequency signal from the detector, the intermediate frequency extraction section comprising a coaxial filter having physical dimensions selected to provide extraction of the intermediate frequency signal.

For example, the substrate may have first and second opposing surfaces and the aperture might extend from the first surface towards or through the second. The mixer and optionally the radio frequency and local oscillator inputs may conveniently each be supported by the first surface and said intermediate frequency extraction section of the filter channel may carry an output signal of the mixer, in use.

In a radiation detector based on a mixer, it is known to provide a filter channel which firstly can block the passage of radio frequencies in order to control the transmission path of received radiation signals in the detector and secondly can extract an intermediate frequency signal to provide an IF output for use for instance in imaging. A known form of filter channel which will operate at radio frequencies is constructed as a planar element whose physical dimensions provide the filtering action and this planar element is conveniently mounted on a surface of a substrate which also supports the mixer and its radio frequency signal input paths as this eases fabrication. In embodiments of the present invention, it has been realised that at least some filtering can be done in a channel which extends into, or through, the substrate instead of lying along a surface of the substrate and that this can deliver significant advantages in terms of packing density of detectors in relation to the substrate and thus improved resolution in overall detection or imaging capabilities.

In known arrangements of filter channels for filtering in the region of RF and IF frequencies, the filter channel is constructed for example as patterned metallisation on a quartz carrier mounted in turn on the surface of the substrate. Clearly this is relatively easily fabricated as a single planar construction. However, it has been realised that the filtering carries out more than one task, for example blocking radio frequencies from travelling inappropriately in the detector and extracting the intermediate frequency ("IF") signal from the mixing product of the mixing chamber for delivery to the IF output, and that there is significant advantage in separating the physical constructions for carrying out these two tasks. The physical construction for performing the second task, extracting the IF signal from the mixing product, has a relatively low frequency pass band and tends to be relatively large in physical dimensions. It will also usually be located towards the IF output of the detector in the sequence of components that provides a detector. In preferred embodiments of the invention, the part of the filter channel which extends into or through the substrate provides a filter construction having a low frequency pass band. The pass band might be for example from 0.1GHz to 60GHz.

Although it would be possible to provide the filter construction having a low frequency pass band as metallisation on a carrier, and to accommodate this in a channel into the substrate, a particularly convenient embodiment of the invention provides this IF passband filter construction as a profiled coaxial pin of generally cylindrical shape. The profiling of the pin can provide the physical dimensions necessary for the filtering action in a manner similar to shaped metallisation on a carrier. Such a pin can be conveniently accommodated for instance in a via of round cross section, directed into the substrate and constructed for example by drilling. Further, it has been realised that a profiled pin lends itself to installation by use of a ferrule mounted in the via which can also be used to provide a hermetically sealed IF output. Preferably, the via is provided with a step change in cross section at a position along its length to provide at least one abutment surface against which the ferrule can be seated.

A known form of filter is a quarter wavelength filter which can be provided as changes in dimension at quarter wavelength intervals in relation to electromagnetic radiation being filtered. It is convenient to construct the profiled pin as a quarter wavelength filter by using changes in diameter at quarter wavelength intervals. This can then be mounted in a generally cylindrical section of the via. Electrically conductive coatings on the pin and the via, and insulating material of the pin, can together provide a coaxial filter.

A suitable general form of construction for use in embodiments of the present invention is the known technology of microstrip patterning on a substrate. Microstrips are a form of transmission line for carrying high frequency signals and generally comprise a thin, flat electrical conductor separated from a ground plane by a layer of insulation or an air gap. They are used as a form of printed circuit design for routing high frequency signals with minimal signal loss due to radiation. A similar technology also suitable for use in embodiments of the invention but more complicated to fabricate is the use of striplines which have two ground planes and the electrical conductor is sandwiched between two respective insulating layers or air gaps. By selective patterning, microstrips and striplines can also be used to deliver and receive electromagnetic waves to and from space and to provide radio frequency filtering. In embodiments of the invention, either one or both of the input for receiving an electromagnetic radiation detection signal and the input for a local oscillator signal might thus be provided by microstrip or stripline circuitry incorporating an antenna, a connection to the mixer, and a radio frequency filter.

In an embodiment of the invention, there may be provided an electrical connection for delivering the intermediate frequency signal from the mixer to the filter, which connection has a length selected to mismatch the electrical load presented by the filter to radio frequency radiation travelling in the detector such that the filter presents at least substantially an open circuit to radio frequency radiation in use of the detector.

Such embodiments of the invention are particularly relevant where the local oscillator input and/or the radio frequency input are constructed at least partially as a transmission line such as a microstrip.

Preferably, the electrical connection is connected to the local oscillator input as this is a good location at which to provide the intermediate frequency output of the detector.

The radio frequency input and the local oscillator input might each comprise at least one electrical conductor and the length of each of said electrical conductors is preferably significantly less than the wavelength of the intermediate frequency signal, in use of the detector. This allows the length of these conductors to be chosen without regard to any effect on the intermediate frequency signal. For example, the length of each of said electrical conductors is preferably not more than one tenth of the wavelength of the intermediate frequency signal, in use of the detector.

In a further embodiment of the invention wherein the mixer is coupled to the local oscillator input and to the radio frequency input by respective transmission lines and the detector further comprises a stub tuner connected to the transmission line of the radio frequency input, the lengths of the stub tuner and said transmission line in combination are selected to optimise coupling of the local oscillator signal to the mixer, in use, and the length of the stub tuner is selected to present an intermediate virtual impedance to the received radio frequency signal.

In said further embodiment of the invention, one stub tuner can play a part in optimising performance of the detector in more than one way. For example, in a detector based on a subharmonic mixer, the length of the stub tuner can be chosen to present a distance equivalent to less than half a wavelength of the local oscillator signal and more than half a wavelength (but less than a whole wavelength) of the received radio frequency signal. It is then possible to choose the lengths of the transmission lines of the radio frequency input and the local oscillator input such that the stub tuner both presents something approaching a virtual short circuit to the local oscillator signal and an intermediate virtual impedance to the received radio frequency signal. Because of its position, being connected to the transmission line of the radio frequency input, the stub tuner is then playing a role in optimising coupling of both the radio frequency input and the local oscillator input to the mixer.

In a convenient form of construction of a detector according to the further embodiment of the invention, the mixer is supported by a primary substrate, the primary substrate having a conductive surface and an end of the stub tuner being connected to said conductive surface. The radio frequency input, the local oscillator input and the mixer may all be mounted on a secondary substrate supported in turn by the primary substrate. For example the secondary substrate may carry the two inputs as printed circuitry to which the mixer is connected. The primary substrate may be provided with an aperture therethrough and the intermediate frequency filter is mounted in the aperture.

It is to be understood that any feature described in relation to any one embodiment may be used alone, or in combination with other features described, and may also be used in combination with one or more features of any other of the embodiments, or any combination of any other of the embodiments.

A THz radiation detector will now be described as an embodiment of the present invention, by way of example only, with reference to the accompanying figures in which:
Figure 1 shows a schematic diagram of the detector in use;
Figure 2 shows schematically, in plan view, part of a structure providing a set of detectors together with their local oscillator feeds and IF outputs;
Figure 3 shows in plan view a mixing portion of a detector from the set of detectors shown in Figure 2;
Figure 4 shows in plan view a quartz-based filter component of the mixing portion of Figure 3;
Figure 5a shows a vertical cross section on the line "A - A" through the mixing portion shown in Figure 3, viewed in the direction indicated by the arrows;
Figure 5b shows a vertical cross section on the line "B - B" through the mixing portion shown in Figure 3, viewed in the direction indicated by the arrows;
Figures 6, 7 and 8 show variations of an intermediate frequency output pin and hermetic seal for use with a mixing portion as shown in Figure 3;
Figure 9 shows a bias "T" circuit viewed from below, for use with the mixing portion shown in Figure 3;
Figure 10 shows a double bank of detecting feedhorns for receiving incoming RF radiation and delivering it to an array of mixing portions as shown in Figure 3 and constructed according to an embodiment of the invention;
Figure 11 shows an alternative substrate arrangement for use in the double bank of detecting feedhorns to accommodate the IF outputs;
Figure 12 shows low and high impedance sections of a quarter wave filter construction that might be used in the output pin arrangements of Figures 6, 7 and 8; and
Figure 13 shows a cross section of a preferred version of the pin and seal arrangements of Figures 6, 7 and 8.

It should be noted that none of the figures is drawn to scale, the figures being schematic only. Like reference numerals are used to indicate like parts on different figures.

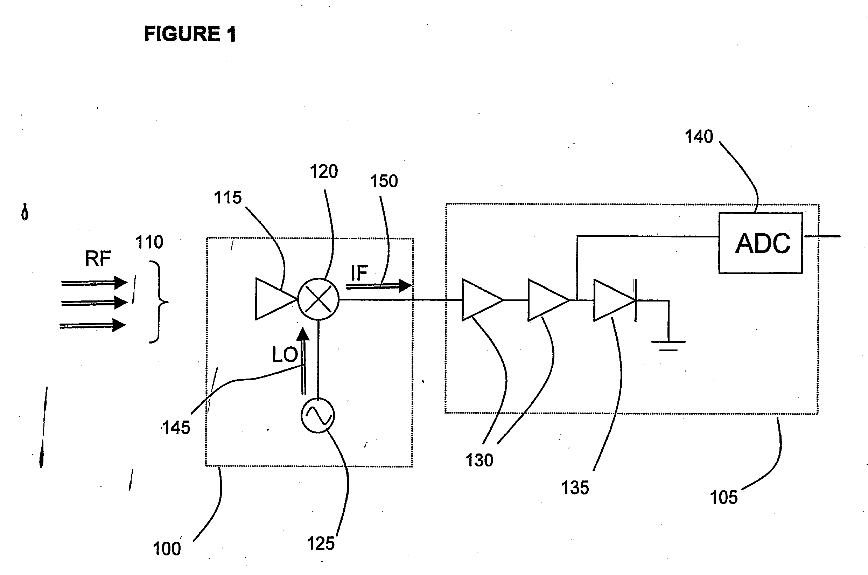

Referring to Figure 1, the detector in general comprises a mixer portion 100 and an amplifying portion 105 for the IF output 150 of the mixer portion 100. The amplifying portion 105 also provides an analogue to digital converter (ADC) 140. Terahertz radiation ("RF signal") 110 incoming from a field of view to the mixer portion 100 is fed into a diode-based mixer 120 by a receiving feedhorn 115 and mixed with a reference signal ("LO signal") 145, here provided by a local oscillator (LO) 125.

The mixer 120 incorporates a nonlinear element such as a pair of Schottky diodes and this combines the received RF signal 110 with the LO signal 145 to produce sum and difference signals, including an intermediate frequency (IF) signal 150. The IF signal 150 is normally low in frequency relative to the received RF radiation 110 and LO signal 145, the relationship being:
- IF signal 150 typically 0.1-40GHz
- RF radiation signal 110 typically 200-10000GHz
- LO signal 145 typically 100-10000GHz

Because the IF signal 150 is low frequency it can be readily amplified, and rectified if necessary, to produce a voltage that is directly proportional in strength to that of the received RF signal 110 and can subsequently be used to form an image in relation to the field of view.

Although referred to herein as a LO signal, it will be understood that the LO signal 145 is also a radio frequency signal and the term "radio frequency" also encompasses signals having frequencies at the lower end of the frequency range of the LO signal 145, unless the context indicates otherwise.

### FEEDHORN/MIXER ARRAY

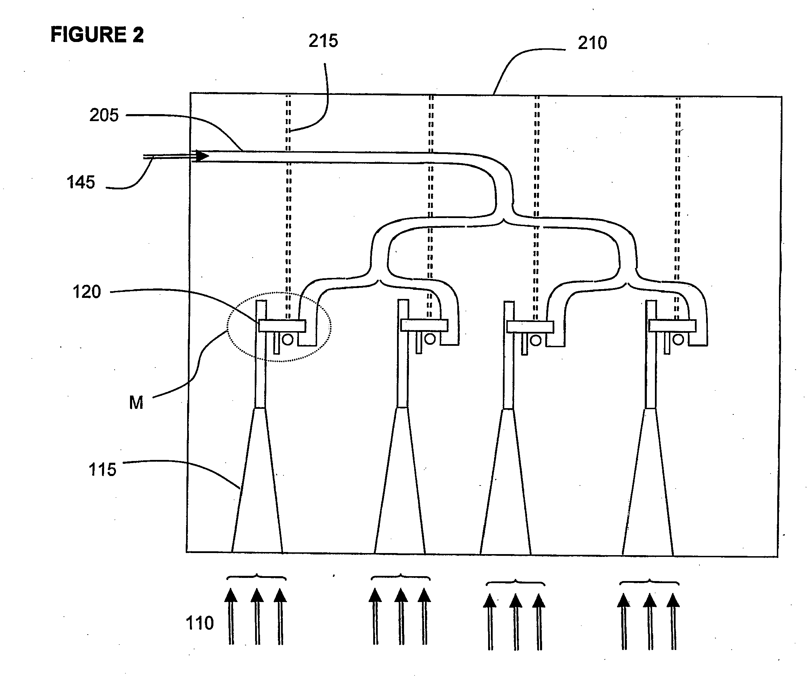

Referring to Figure 2, the feedhorn 115 and mixer 120 can in practice be built as part of an array of feedhorns on a shared, primary substrate 210, each with its mixer. One local oscillator (not shown in Figure 2) can supply a LO signal 145 along a branched path 205 to several of the mixers 120. Paths 215 for the IF outputs from each of the mixers are provided in the substrate 210, in a direction away from the feedhorns 115.

The general construction of the array shown in Figure 2 can be fabricated by epitaxial methods as described in International Patent Application WO 2004038854 in the name Agence Spatiale Européenne. That is, a three layer structure is made, the middle layer, the shared substrate 210, being etched on both faces and upper and lower layers being etched in a complementary fashion on just one face. Figure 2 shows only a plan view of the middle layer of such a construction and does not show the upper and lower layers. When the upper and lower layers are brought into registration with the middle layer, a double array of feedhorns 115, locations for the mixers 120 and input channels 205 for LO signals is created. The dotted outline "M" indicates the area particularly housing the mixer 120 of a detector and its inputs and outputs.

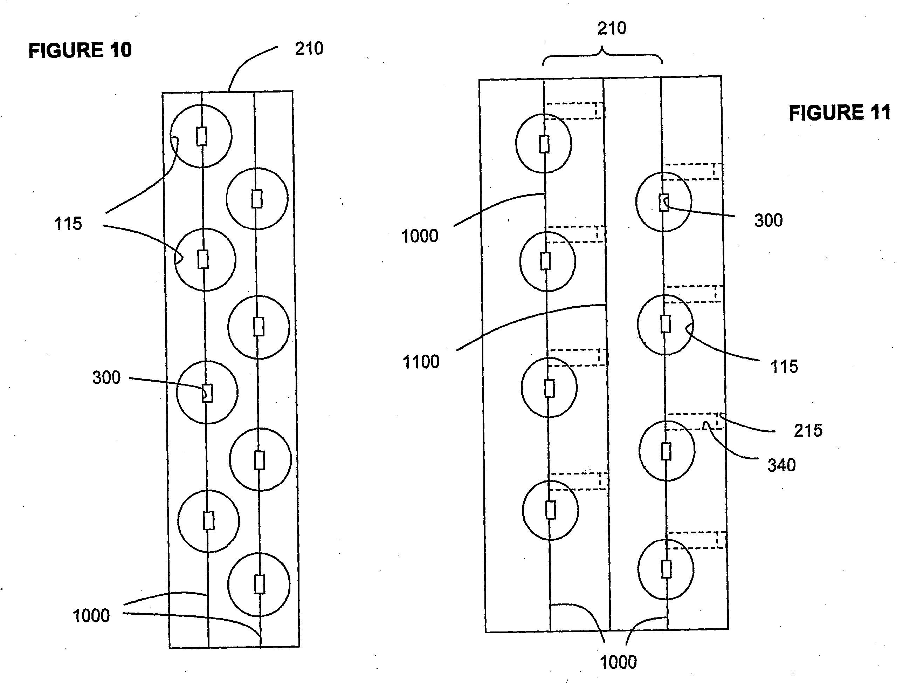

In practice, the number of layers can be increased to any number required, supporting a wide range of designs of feedhorn array, as long as meeting surfaces of the layers are etched in the necessary complementary fashion. This is further discussed below with reference to Figures 10 and 11.

The material of any of the layers of the three layer substrate can be for example a semiconductor such as silicon, or a metal, provided the material of the surface has high electrical conductivity. For example, a silicon layer might be metallised with gold or silver. An alternative method of creating the complimentary patterning is machining instead of etching.

### SIGNAL INPUTS AND OUTPUT: A SINGLE MIXER 120

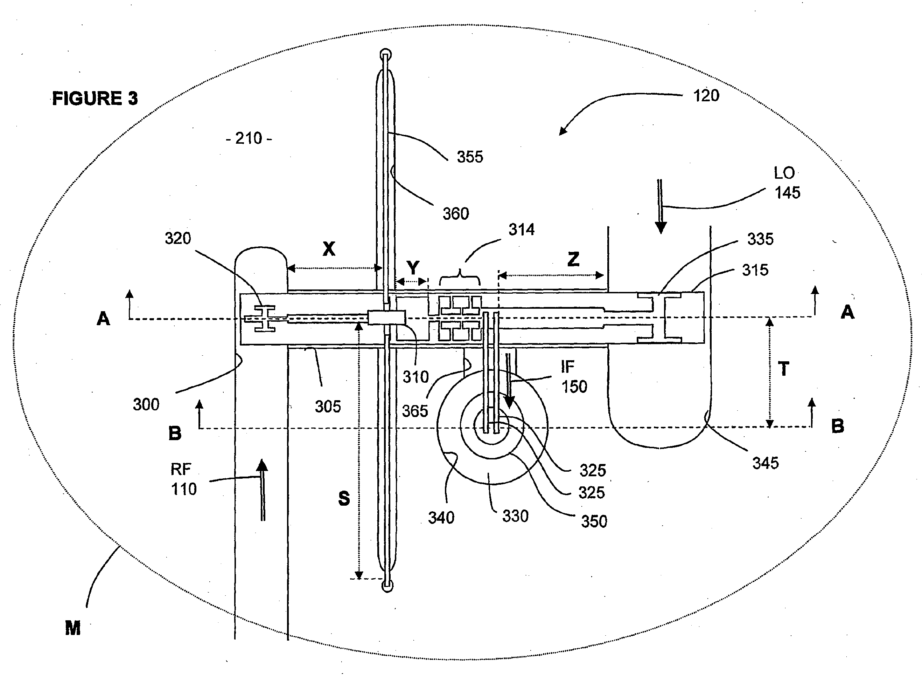

Referring to Figure 3, the area "M" housing the mixer 120 in more detail comprises the end of a waveguide 300 delivering the incoming RF signal 110 and the end of a second waveguide 345 delivering the local oscillator signal 145. Extending between the two waveguide ends 300, 345, there is a shallow channel 305 housing a gold coated quartz substrate 315. The gold coating on the quartz substrate 315 is patterned to provide:
- two antennae 320, 335, one at either end of the substrate 315, for coupling the RF and LO signals 110, 145 from the waveguide ends 300, 345
- support and connections to a diode chip 310 for mixing the respective RF and LO signals 110, 145 delivered by the antennae
- a high frequency filter 314 (the "RF filter") to block the incoming RF signal 110 from travelling further.

These forms of antennae 320, 335 and high frequency filter 314 are known and therefore are not described in detail herein. Each could take other known forms.

A filter channel relating to the mixer 120 includes the high frequency filter 314 mentioned above and an IF output filter 350. The IF output signal 150 from the diode chip 310 is picked off from an end of the microstrip antenna 335 delivering the LO signal 145 by a pair of wire connectors 325 and delivered to the IF output filter 350. The IF output filter 350 is in the form of a profiled pin, mounted so that its longitudinal axis extends into the shared substrate 210, through a via 340. Thus the longitudinal axis of the output filter 350 is transverse both to the plane of the quartz substrate 315 carrying the antennae 320, 335 and the diode chip 310, and to the face of the shared substrate 210 supporting the quartz substrate 315. This orientation of the IF output filter 350 allows relatively close packing of mixers 120 on the shared substrate 210 and thus potentially improved resolution in images obtained.

It might be noted that the diode chip 310, although not mounted directly on the shared primary substrate 210, is supported by it via the intervening (secondary) quartz substrate 315.

Where the shared primary substrate 210 is not itself a metal material, the shared substrate 210 and the two waveguides 300, 345 are metallised on the surface shown in Figure 3 and earthed. The metallisation comprises electroplated gold, or other highly conductive material of similar anti-corrosion material properties, at least one micron thick. The surface of the IF output via 340 is likewise metallised. The metallisation is further discussed below in relation to stub tuners used in embodiments of the invention and in relation to the performance of the IF output filter 350.

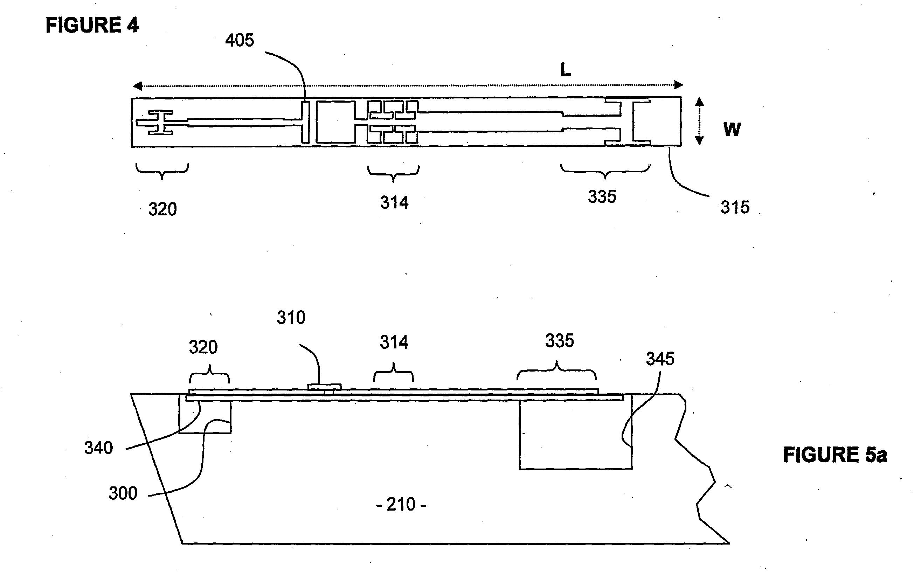

Referring to Figure 4, the gold coated, secondary quartz substrate 315 has a thickness of about 75 microns. It has a width "W" of approximately 350 microns and a length "L" of about 2.5 mm. The gold coating is applied in known manner, using vacuum deposition and photolithographic techniques, to create an RF antenna 320 for picking up incoming RF signals 110 from the RF waveguide 300, an LO antenna 335 for picking up the LO signal 145 from the LO waveguide 345, and an RF filter 314 for blocking the incoming RF signals 110 from reaching the LO antenna 335.

Referring additionally to Figure 3, the diode chip 310 is first mounted between the RF antenna 320 and the RF filter 314 on the gold coated quartz substrate 315. The RF antenna is provided with a transverse "T-bar" 405 at its end, partly for this purpose. The diode chip 310 is mounted using standard soldering techniques in order to make electrical connections to the RF antenna 320 and the RF filter 314. The assembly comprising the diode chip 310 and the gold coated quartz substrate 315 is then mounted in the shallow channel 305 in the shared substrate 210 by using an ultra-violet ("UV") curing epoxy material such as Norland 61 (registered trade mark of Norland Products Inc.).

Referring to the cross section shown in Figure 5a, it can be seen that the diode chip 310 bridges a gap between the end of the RF antenna 320 and the RF filter 314, providing an electrical path between the two. The incoming RF signals 110 and the LO signals 145 are both thus delivered to the diodes (not shown) on the diode chip 310. The diode chip 310 in use provides mixing of the incoming RF signals 110 and the LO signals 145 to create the IF signal 150 which is used for detection. Diode chips of this type are known and discussed for example in co-pending British patent application GB 0603193.4 which discloses use of a non-linear mixing element comprising a pair of Schottky diodes, in anti-parallel configuration. Suitable diodes for use in embodiments of the present invention are described in the following publication:
"Glass Reinforced GaAs Beam Lead Schottky Diode with Airbridge for Millimetre Wavelengths", published in Electronics Letters, 13th September 1984, Vol. 20 No.19 Page 787.

### IF FILTER

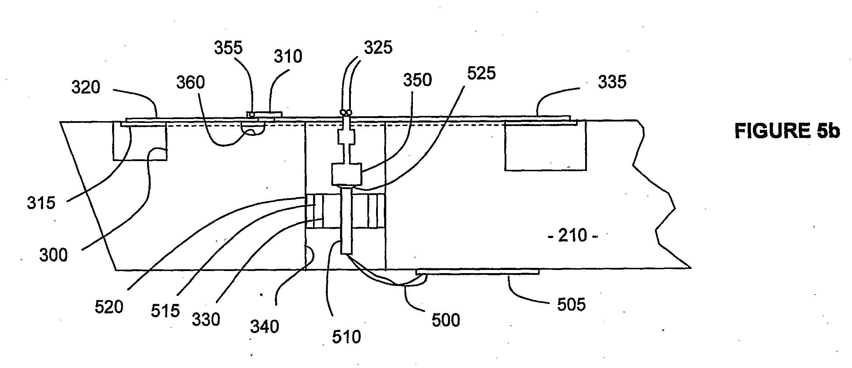

Referring to Figures 3 and 5b, the shared substrate 210 has a via 340 created through it which houses the IF output filter pin 350. The IF output pin 350 is held in place by a glass support bead 330. The pin 350 itself is machined from beryllium copper alloy and gold-plated, then attached by silver loaded epoxy 525 to a centre conductor 510 of the glass bead 330. Glass beads suitable for use in providing a hermetic feedthrough for a housing wall, between a connector and a microcircuit, are supplied by manufacturers such as Anritsu Corporation. The bead 330, in turn, has an outer conductor 515 in a coaxial configuration with the centre conductor 510 and is fixed to the via 340 using an indium-based solder material 520. The outer conductor 515 is earthed by means of the metallisation within the via 340.

The pin 350 and glass support bead 330 with its centre conductor 510 have at least three functions:
- the cross section of the pin 350 is profiled according to known principles to pass only the IF output signal 150 from the diode chip 310, blocking the LO and RF signals 145, 110
- the centre conductor 510 of the bead 330 and the gold plating of the pin 350 can be used in delivering a bias current or voltage to the diode chip 310
- the glass bead 330 provides a hermetic seal around the IF output, thus protecting • the environment of the area "M" housing the mixer 120 in the finished product

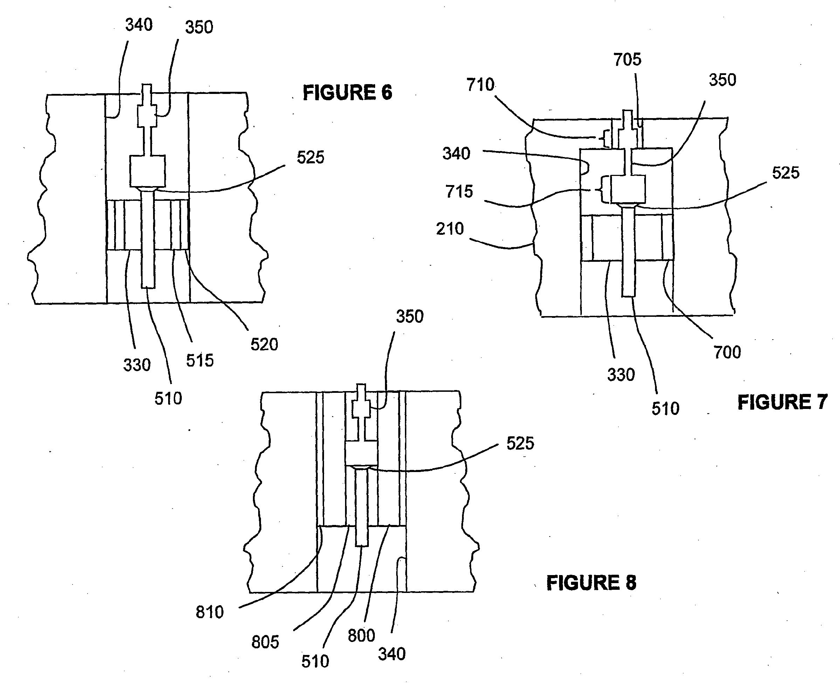

Referring to Figures 6, 7 and 8, the pin 350 and the support bead 330 can be arranged in more than one way. Figure 6 shows a cross section of an arrangement as described above with reference to Figure 5b. Figure 7 shows an arrangement in which the glass bead 330 has no outer conductor of its own but is mounted in the metallised via 340 using an UV curing epoxy material 700. This arrangement avoids the use of solder and thus simplifies manufacture. Figure 8 shows a slightly different arrangement in which the pin 350 is first attached to the centre conductor 510, again using silver loaded epoxy 525, and then both are mounted within a quartz ferrule 800 by the use of UV curing epoxy material 805. The quartz ferrule 800 is also mounted in the via 340 by the use of UV curing epoxy material 810.

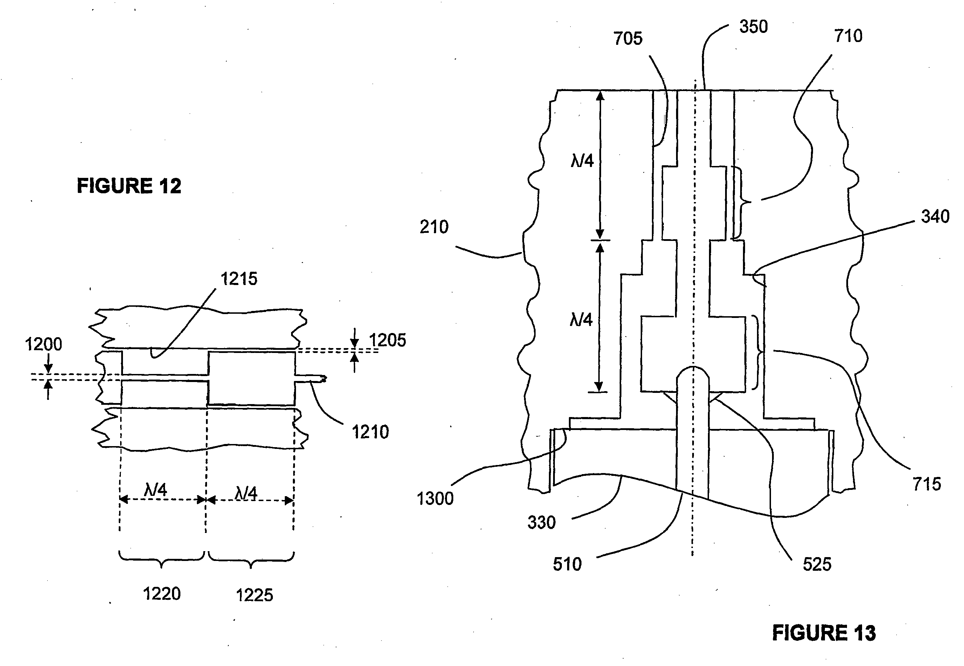

Referring to Figure 12, the principles underlying the profiling of the cross section of the pin 350 are discussed for example in "Microwave Filters, Impedance Matching Networks and Coupling Structures" by G Matthaei, L Young and EMT Jones, SBN 0-89006-099-1, and at page 668 in "Very High Frequency Techniques", Volume II, published by the McGraw Book Company Inc., New York & London, 1947. In general, coaxial filters of this type have been used for many years and their design is well understood and explained in the references given. Their basic operation is based on alternating sections of high or low impedance depending on the diameter of a generally cylindrical central structure 1210 with a conductive outer surface in relation to that of a coaxial channel 1215 with a conductive inner surface. In the arrangements shown in Figures 6, 7 and 8, the central structure 1210 is represented by the pin 350 and the channel is represented by the via 340 in which the pin 350 is mounted. The central structure 1210 and coaxial channel 1215 together provide a "quarter wave filter" in which high and low impedance sections 1220, 1225 are cascaded in series. The lengths of each section 1220, 1225 are approximately 7J4 where λ is the wavelength of the electromagnetic wave in the coaxial line. Hence the term "quarter wave filter". In Figure 12, a high impedance section 1220 having a small diameter section of the central structure 1210 is shown cascaded with a low impedance section 1225 having a larger diameter section of the central structure 1210. In the high impedance section 1220, the diameter 1200 of the central structure 1210 is minimised. In the low impedance section 1225, the clearance 1205 between the central structure 1210 and the channel 1215 is minimised. In order to achieve greater rejection, either the number of cascaded sections 1220, 1225 can be increased, this having the disadvantage of increasing insertion losses, or the diameter 1200 of the central structure 1210 and/or said clearance 1205 can be reduced, this having the disadvantage of making construction more difficult.

In embodiments of the invention as shown for example in Figures 6, 7 and 8, the length of the whole pin 350 is two λ/4 distances with respect to the IF signal and the profile of the pin 350 within each λ/4 section is stepped rather than smooth so that the pin 350 has two "ribs" 710, 715 around it, one larger than the other. This construction is shown in more detail in Figure 13. The purpose of this construction is to minimise unwanted mode generation in the first λ/4 section, which has the smaller rib 710, while easing the mechanical requirements of fabrication as far as possible by generally increasing the dimensions associated with the second λ/4 section of the pin 350.

Referring to Figures 7 and 13, in order to reduce the presence of unwanted modes that could potentially propagate through the coaxial filter pin structure it is important that the entrance to the filter from the high frequency local oscillator side presents a small dimension, typically less than lambda/4 ("λ/4") with regard to the local oscillator wavelength, in diameter. (The "entrance to the filter" is the first section of the pin 350 to which the wire connectors 325 are attached.) However, if the diameter of the pin 350 in this region is reduced to λ/4 with respect to the local oscillator wavelength, this brings a conflict between the requirement for a physically robust structure and the best operation of the filter from a rejection perspective. The wavelength of the local oscillator is considerably less than that of the IF signal 150 and thus the diameter of the pin 350 at the entrance to the filter would have to be very slight. In order to alleviate this problem, the profile of the pin 350 in its first λ/4 section has the "rib" 710 while the inner diameter of the via 340 is narrowed in this section to provide a neck 705 that comes very close to the rib 710. The clearance between the neck 705 of the via 340 and the rib 710 on the pin 350 is reduced to the minimum practicable, this providing the small dimension required at the entrance to the filter while retaining the diameter of the pin 350 at a dimension that is easier to fabricate than λ/4 of the local oscillator wavelength. This construction complicates the machining requirement compared with the constructions shown in Figure 6 and 8, by introducing the neck 705 in the via 340, but provides optimum filter response combined with structural rigidity.

The pin 350 has a second λ/4 section with the second, larger rib 715. Here the dimensions are generally less critical and the clearance between the via 340 and the second rib 715 is greater while the second rib 715 itself can be larger than the first rib 710 on the pin 350. It is possible to achieve a rejection of the local oscillator signal of up to 10dB↓ before it reaches this second λ/4 section so that there will be no mode generation in the second λ/4 section. Using generally increased dimensions of the via 340 and the second λ/4 section of the pin 350 reduces the difficulty of fabrication and maintains mechanical strength.

Referring to Figure 13, in a variation of the arrangement shown in Figure 7, the pin 350 is unchanged but the cross section of the via 340 is more complex. The entrance to the filter and the first λ/4 section of the filter, including the neck 705 of the via 340, are the same as the version shown in Figure 7. It is in the second λ/4 section of the filter where the internal surface of the via 340 is more complex. Where the version shown in Figure 7 has a via 340 which is just a cylindrical hole from the neck 705 to the other surface of the substrate 210, in the version shown in Figure 13, the internal surface of the via 340 has a stepped profile which is still less in diameter than the glass support bead 330. At the glass support bead 330, there is a further step in the internal surface of the via 340, this step providing an abutment surface 1300 for the shoulder of the glass support bead 330. Such as arrangement aids in assembling the filter since the pin 350 can first be mounted on the centre conductor 510 of the glass bead 330 and then the bead 330 located against the abutment surface 1300 in the via 340.

It might be noted here that the end of the centre conductor 510 of the glass bead 330 can protrude into the pin 350 slightly, this also making alignment of the pin 350 in the via 340 potentially more accurate and the mounting of the pin 350 more mechanically stable.

Referring to Figure 3, a factor in the performance of the IF filter, comprising the pin 350 and the via 340, is the delivery of the IF signal to the pin 350. This is done via a pair of wires 325 and the attributes of these wires 325 are further discussed below under the heading "STUB TUNING".

### FILTERED IF OUTPUT

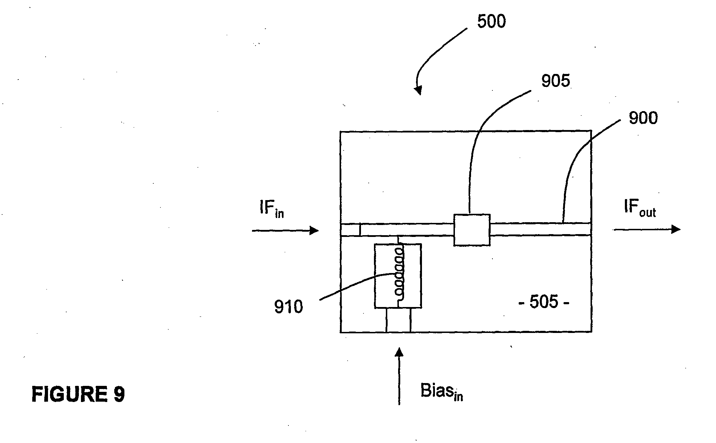

Referring to Figures 5b and 9, the IF output of the mixer carried by the centre conductor 510 is delivered for use, for example in imaging, by means of gold bond wires 500 and a bias delivery circuit 500. The bias delivery circuit 500 is transparent to the IF output signal 150 which can thus be delivered across it to amplifying and imaging equipment. The strength of the bias delivery circuit 500 is that it can be used for delivering a direct current ("DC") bias voltage or current "in the other direction" to the diode chip 310.

In more detail, the bias delivery circuit 500 comprises an alumina substrate 505 carrying a transmission line connection 900 for the IF signal 150 across the circuit 500. In general, the action of the bias delivery circuit 500 is of known type and it is not described in detail herein. A DC blocking capacitor 905 is provided in the transmission line 900 which blocks the DC bias signal but is transparent to the IF output signal 150. A bias inductor 910 is connected to the transmission line 900 in a "T" configuration for delivery of the DC bias signal and blocking of the IF signal 150. The DC bias signal is transmitted through the gold bond wires 500 to the centre conductor 510 of the glass bead 330 for onward transmission to the diode chip 310.

The bias delivery circuit 500 is made according to industry standard assembly procedures. The capacitor 905 might be for example supplied by a company such as Presidio Components Inc and the inductor 910 by a company such as Piconics Inc.

### STUB TUNING

As in most detection, an important aspect of embodiments of the invention is the signal to noise ratio of the detected signal. It is known to improve the performance of devices operating at radio frequencies by using stub tuners to improve coupling of power at significant points such as into a load. Stub tuners can be provided as shorted or open circuit lengths of transmission line which produce a pure reactance at their attachment point. Any value of reactance can be made by varying the length of the stub tuner from zero to half a wavelength but each stub tuner will only work effectively at one frequency. It is also known to use more than one stub tuner in order to broaden the frequency spectrum at which a device will function well.

Referring to Figures 3 and 5b, in more detail, coupling microwave power to a load such as the diodes of the diode chip 310 requires the respective complex impedances between the load and the microwave power delivery component to be matched. In the embodiment described above, there are two power delivery components delivering microwave power to circuitry including the diode chip 310, these being the waveguides 300, 345 delivering the RF signals 110 and the LO signals 145 respectively.

A common means to achieve an impedance match between a capacitive reactive impedance such as the diode chip 310 and a real impedance such as the RF and LO waveguides 300, 345 is to insert an extra transmission line element into the circuit to 'tune' the circuit's behaviour to provide the right shift in phase to compensate for the reactance of the diodes. However, since the impedance of the diodes in the diode chip 310 has both phase and amplitude components, both position and dimensions of the matching transmission element affect the result.

In embodiments of the invention, delivery of the RF and LO signals 110, 145 to the diode chip 310 itself is done via microstrip antennae 320, 335. The antennae 320, 335, all of the patterned gold coating on the quartz substrate 315 and the diode chip 310 together constitute a mixer circuit. In the context of microstrip circuitry for dealing with high frequency signals, multi-stub tuners are known which accomplish both position and insertion adjustments in the form of one or more transmission lines or 'stubs' inserted into the circuit. This use of multiple transmission line stub tuners can be used to increase the bandwidth over which the mixer circuit is 'matched'.

In embodiments of the invention, it has been realised that stub tuners can be provided in the form of wires 355, 325 and that these can perform more than one role. Two gold bond wires 355 are provided which are attached to the end of the RF signal microstrip antenna 320 and two more gold bond wires 325 are used to pick off the IF signal at the end of the LO signal microstrip antenna 335 for delivery to the output pin 350. The first pair of gold bond wires 355 is present simply for stub tuning while the second pair of wires 325 has a multiple role since they act as follows:
- assist in tuning out the effect of the IF circuit with respect to the LO signal
- form a robust mechanical interface from the circuitry on the quartz substrate 315 to the IF pin 350
- carry the IF output signal 150 to the pin 350.

### (The "IF circuit" is further discussed below.)

The design of any tuning stubs present is critical for optimally matching all of the incident power into the mixer diodes, over the wavelength range of the radiation to be coupled. A factor is the length of the stub in relation to the wavelength range and this means that a single stub tuner tends to operate well only over very narrow bandwidths. It is consequently known to use more than one stub tuner in order to increase the operating bandwidth. In embodiments of the present invention, it has been realised that it is possible and appropriate, by selecting appropriate dimensions, to use elements already present in the detector in a secondary role in tuning to improve the overall performance of the detector.

The exact lengths of the tuning stubs present in embodiments of the present invention will be affected by the type of Schottky diodes used in the diode chip 310 since this affects the load presented by the diode chip 310. The exact manner in which they are affected is complex and difficult to calculate and thus it is best for any one embodiment to select the lengths of the tuning stubs empirically. An optimum arrangement will be found by maximising signal power delivery and minimising noise generated. The exact balance that is found acceptable may also vary, depending on characteristics of other components in the system, such as filtering and available signal power levels.

Referring to Figure 3, there are two coupling points where radio frequency power is coupled into a load and this is at either end of the diode chip 310 where the RF signal 110 and the LO signal 145 are delivered for mixing. The frequencies of these signals are 120-130GHz and 220-280GHz respectively. In order to couple all of the power into the diode chip 310 from each antenna 320, 335, it is important that the potential onward path for the respective signals in leaving the diode chip 310 towards the opposing antenna presents an open circuit. This can be satisfactorily achieved in the manner described below.

It might be noted here that the tuning behaviour of a stub tuner repeats as the length of the tuner is increased by one wavelength "λ" in relation to the signal it is dealing with. Therefore, if the appropriate length of a tuner to achieve a particular effect is found to be 1/4 λ, then similar behaviour will be achieved for a length of 1 1/4 λ. (There will however be increased loss due to the ohmic resistance of the extra length of transmission line and also bandwidth restrictions if the transmission line is dispersive.) This means that one stub tuner can be used to have different effects in relation to signals in a number of different wavebands, not necessarily just wavebands which have a subharmonic relationship, because the length can be adjusted to present the right fraction of wavelength in each case despite the length further incorporating a whole number of wavelengths in relation to one or both wavebands.

In the arrangement of Figure 3, the overall preferred passage of signals is:
1. delivery of the LO signal 145 from the LO waveguide 345 to the diode chip 310 and no further ("LO circuit")
2. delivery of the RF signal 110 from the RF waveguide 300 to the diode chip 310 and no further ("RF circuit")
3. delivery of the mixed LO/RF signals from the diode chip 310 to the IF output pin 350 ("IF circuit")

It is also desired to tune the performance of the circuitry empirically, using stub tuning.

These desired signal paths and the tuning are achieved as follows:

### 1. LO circuit

The two bond wires 355 are earthed at their free ends by ultrasonically bonding them to the metallised surface of the mixer substrate 210. The point where each bond wire joins the substrate 210 forms a physical short circuit at radio frequencies which effectively locks both the LO and RF circuits' behaviour to a short circuit at this physical point. All other lengths are then relative to this position. This is true in terms of both phase and magnitude. Being a physical rather than virtual short circuit this short circuit is common to both the RF and LO frequencies.

For this embodiment, the length "S" of the bond wires 355 is 1039µm, approximately 3/8 λ at the LO frequency and thus does not provide a perfect virtual short circuit at the diodes. A perfect short circuit at the diode chip 310 would be attained if their length were ½ λ. Such a condition would couple most of the LO signal 145 to the diodes but being λ at the RF signal 110 would short all of the incoming RF signal 110 to ground. The length "S" of the bond wires 355 and the length "X" of the microstrip between the RF waveguide 300 and the bond wires 355 in practice work in conjunction to affect coupling of the LO signal 145 to the diode chip 310. With the length "S" set to an intermediate length, it allows the length "X" to be varied to provide optimum coupling at the LO frequency. Changing the length "X" however has minimal effect on the RF signal 110.

### 2. RF circuit

Meanwhile, the length "S" of the two bond wires 355 is approximately ¾ λ at the RF frequency which presents an intermediate virtual impedance to the diode chip 310 (that is, something between an open circuit and a short circuit at the RF frequency). Now it is possible to vary the length "Y" of a microstrip section between the diode chip 310 and the RF filter 314 to provide optimal coupling to the diode chip 310 at the RF frequency. Changing the length "Y" has minimal effect on the LO signal 145.

### 3. IF circuit

It is desirable that the IF signal output is invisible to the LO circuit. The connection to the filter pin 350 is provided by a second pair of gold bond wires 325 which are connected at their far end to the gold-plated filter pin 350. The same principles apply as described above in relation to the bond wires 355 in the RF circuit. In this case, there is only the LO frequency to consider as the second pair of gold bond wires 325 is attached beyond the high frequency filter 314 blocking the RF signal 110. The length of the wires 325 to the filter pin 350 ("T" as shown on Figure 3) is then selected such that, when combined with the IF filter pin assembly, the effect of the IF output overall is minimised with respect to the LO coupling to the diode chip 310. The wires 325 can be rendered substantially invisible to the LO signal 145 by selecting a length which detunes, or tunes out, the load presented by the IF output at the LO frequency. In practice, the length "T" is chosen empirically, allowing for the parasitic reactances associated with the interconnection between the bond wires 325 and the pin 350, and the length of the first section of the pin 350, to provide as far as possible a radio frequency open circuit to the LO signal 145 of the filter. If these factors in combination present a λ/4 or λ/2 length at the LO frequency, there will be in phase reflection and the desired open circuit. In the embodiment described above, a suitable length "T" is 570 µm.

As the IF frequency is very much less than either the RF or LO signals 110, 145, the wavelength of the IF signal 150 is long compared to the dimensions of the stub tuner bond wires 355. Consequently, the length of the wires 325 has very little effect on the IF circuit and can be optimised just for their effect on the LO circuit. The length "T" is kept as short as practically possible in this respect, so that there is minimal effect to the IF signal path. The length "Z" of the microstrip between the stub tuner bond wires 355 and the LO waveguide 345 is also minimised for the same reason. In order to minimise the effect of either on the IF circuit, it is preferred to keep both "T" and "Z" to below a tenth of the IF wavelength. Thus if the IF frequency is 20 GHz, the IF wavelength is 15mm and thus "T" and "Z" should be not more than 1.5mm if possible.

Information on the known principles of stub tuning is available for example in: "High Frequency Techniques: An Introduction to RF and Microwave Engineeering", Joseph F. White, published by Wiley-IEEE Press in January 2004.

In practice there are many variations that could be made, although for the mixer design to achieve the greatest bandwidth the stub tuners delivering power to the diode chip 310 are required to be positioned as close to it as possible. It might be found beneficial to add one or more stub tuners at further positions along the microstrips whose lengths are marked "X" and "Y" in Figure 3 to provide some additional fine tuning of either the RF or LO signals 110, 145 but on the other hand this might introduce more interaction between the LO tuning circuit and the RF tuning circuit. It will be understood that although the various parts of the circuitry shown on the quartz substrate 315, particularly those having distances marked as "X", "Y" and "Z", are shown in line, this is not essential. Neither is it essential that the stub tuners are orthogonal.

A design implemented as described above effectively provides two circuits, the RF and LO circuits, which are isolated from one another. This allows each circuit to be adjusted to provide optimal performance at either the LO or RF frequency whilst causing minimal disruption to the other. Key to allowing this is the use of the additional pair of bond wires 355 at the coupling of the RF signals 110 to the diode chip 310.

It is an option to use only one bond wire 355, 325 in each of the LO and IF circuits but two bond wires 355, 325 in each case make it possible to fine tune the circuits empirically by changing the lengths such that they are slightly different and provide redundancy.

Referring to Figures 2, 10 and 11, it is mentioned above that an array of feedhorns 115 can be constructed by building up the number of substrate layers 210. This is true in principle as long as the IF output 215 can be taken backwards out of the array, in a direction away from the feedhorns 115 and orthogonal to the filter pin 350 and its via 340. In practice, as can be seen in Figure 2, this may conflict with the branched path 205 delivering the LO signal 145 to the mixers 120 of the next layer. Figure 11 shows a solution to this conflict in that a shared substrate 210 is in practice two sub-layers, the two sub-layers together providing interfaces 1000 where the quartz substrates 315 carrying the diode chips 310 can be housed but also providing an interface 1100 where the IF outputs 215 can be accommodated.

Embodiments of the invention are particularly useful in optimising performance of detectors based on subharmonic mixers operating at the second harmonic but could be used in operation at higher harmonics.

In embodiments of the invention according to its third aspect, the length of the stub tuner might present a distance equivalent, in use of the detector, to less than half a wavelength of the local oscillator signal, or the length of the stub tuner might be equal, in use of the detector, to less than half a wavelength of the local oscillator signal. The stub tuner might comprise at least one wire and/or at least two conductive elements of different lengths. The local oscillator input might comprise a radio frequency filter for limiting travel of received radio frequency signals in the detector and/or a transmission line connecting the radio frequency filter to the mixer, the length of said transmission line being selected in conjunction with the length of the stub tuner to optimise coupling of the received radio frequency signal to the mixer, in use. The length of the stub tuner might present a distance equivalent, in use of the detector, to more than half a wavelength but less than a whole wavelength of the received radio frequency signal and/or equal, in use of the detector, to more than half a wavelength but less than a whole wavelength of the received radio frequency signal. The mixer can be supported by a substrate, the substrate having a conductive surface and an end of the stub tuner being connected to said conductive surface. The radio frequency input, the local oscillator input and the mixer can all be mounted on a shared substrate supported in turn by the substrate having a conductive surface. The substrate having a conductive surface can be provided with an aperture therethrough and the intermediate frequency filter mounted in the aperture.

## Claims

1. An electromagnetic radiation detector comprising:
i) at least one substrate (210);
ii) a radio frequency input (320, 310, 314) for receiving radio frequency signals to be detected;
iii) a local oscillator input (335, 310) for receiving a local oscillator signal;
iv) a mixer (120, 310) supported by the substrate (210) and coupled to the radio frequency input and the local oscillator input for use in generating an intermediate frequency signal by mixing a received radio frequency signal with the local oscillator signal; and
v) a filter channel (314, 325, 350) for use in controlling passage of radio frequency signals in the detector and in extracting the intermediate frequency signal,
wherein the substrate (210) is provided with an aperture (340) having an axial direction which extends into the substrate (210),
**characterised in that** the aperture (340) accommodates an intermediate frequency extraction section (350, 1210, 1215) of the filter channel for extracting the intermediate frequency signal from the detector, the intermediate frequency extraction section (350, 1210, 1215) comprising a coaxial filter having physical dimensions selected to provide extraction of the intermediate frequency signal.

2. A detector according to Claim 1 wherein the substrate (210) has first and second opposing surfaces and the axial direction of the aperture (340) extends from the first surface to the second.

3. A detector according to Claim 2 wherein the mixer (120, 310) is supported by said first opposing surface of the substrate (210).

4. A detector according to any one of the preceding claims wherein said coaxial filter comprises a quarter wavelength filter (1210, 1215).

5. A detector according to any one of the preceding claims wherein the coaxial filter comprises a generally cylindrical section (1215) of the aperture (340) and a pin (350, 1210) of generally cylindrical cross section, the pin being mounted coaxially in said cylindrical section.

6. A detector according to Claim 5 wherein the cylindrical section (1215) of the aperture (340) has a surface of electrically conductive material and the pin (350, 1210) comprises an electrically insulating material having an electrically conductive coating on its cylindrical surface or surfaces, these together providing the coaxial filter.

7. A detector according to any one of Claim 4, 5 or 6 wherein the coaxial filter comprises a pin (350, 1210) of generally cylindrical cross section, the pin having at least two sections (1220, 1225) of different respective diameters to provide said quarter wavelength filter.

8. A detector according to any one of the preceding claims, further comprising a hermetic seal (330), sealing said intermediate frequency extraction section (350, 1210, 1215) of the filter channel in the aperture (340).

9. A detector according to any one of Claims 5, 6 or 7 wherein the pin (350, 1210) is mounted in said cylindrical section (1215) by means of an annular element (330) to provide a hermetic seal to the aperture (340).

10. A detector according to Claim 9 wherein said cylindrical section (1215) of the aperture (340) has a step change (1300) in cross section to provide at least one abutment surface against which the annular element is seated.

11. An electromagnetic radiation detector according to any one of the preceding claims, wherein the local oscillator input (335, 310) is adapted to receive a radio frequency local oscillator signal, and wherein there is provided an electrical connection (325) for delivering the intermediate frequency signal from the mixer (120, 310) to the intermediate frequency extraction section (350, 1210, 1215) of the filter channel, which connection (325) has a length (T) selected to mismatch the electrical load presented by the filter channel to radio frequency radiation travelling in the detector such that the filter channel presents at least substantially an open circuit to radio frequency radiation in use of the detector.

12. A detector according to Claim 11 wherein said electrical connection (325) is connected to the local oscillator input (335, 310).

13. A detector according to either one of Claims 11 or 12 wherein the radio frequency input (320, 310, 314) and the local oscillator input (335, 310) each comprise at least one electrical conductor and the length (X, Y, Z) of each of said electrical conductors is significantly less than the wavelength of the intermediate frequency signal, in use of the detector.

14. A detector according to Claim 13 wherein the length of each of said electrical conductors is not more than one tenth of the wavelength of the intermediate frequency signal, in use of the detector.

15. A detector according to either one of Claims 13 or 14 wherein each of said electrical conductors comprises a transmission line.

16. A detector according to any one of Claims 11 to 15 wherein the electrical connection (325) for delivering the intermediate frequency signal from the mixer (120, 310) to the intermediate frequency extraction section of the filter channel comprises at least one wire.

17. A detector according to any one of the preceding claims wherein the mixer (120, 310) comprises a subharmonic mixer.

18. A detector according to any one of the preceding claims wherein the mixer (120, 310) comprises a pair of balanced diodes.

19. A detector according to any one of the preceding claims wherein the local oscillator input (335, 310) and/or the radio frequency input (320, 310, 314) are constructed at least partially as a transmission line such as a microstrip.

20. A detector according to claim 19 wherein either one or both of the input (320, 310, 314) for receiving an electromagnetic radiation detection signal and the input (335, 310) for a local oscillator signal are provided by microstrip or stripline circuitry incorporating an antenna (320, 335), a connection to the mixer (120, 310), and a radio frequency filter 314.

21. A detector according to any one of the preceding claims, wherein the mixer (120, 310) is coupled to the local oscillator input (335, 310) and to the radio frequency input (320, 310, 314) by respective transmission lines and the detector further comprises a stub tuner (355) connected to the transmission line of the radio frequency input (320, 310, 314), the lengths (X, S) of the stub tuner and said transmission line in combination being selected to optimise coupling of the local oscillator signal to the mixer (120, 310), in use, and the length of the stub tuner (S) being selected to present an intermediate virtual impedance to the received radio frequency signal.

22. A detector according to claims 20 and 21, wherein the length "Y" of a microstrip section between the mixer (120, 310) and the radio frequency filter (314) is selected to provide optimal coupling to the mixer (120, 310) at the frequency of the received radio frequency signal.

23. A detector according to any one of the preceding claims wherein the intermediate frequency extraction section (350, 1210, 1215) comprises a filter construction having a frequency pass band from 0.1 GHz to 60GHz.

24. A terahertz radiation camera comprising a detector according to any one of the preceding claims.

## Patentansprüche

1. Detektor für elektromagnetische Strahlung, aufweisend:
i) mindestens ein Substrat (210);
ii) einen Hochfrequenzeingang (320, 310 314) zum Empfangen von zu erfassenden Hochfrequenzsignalen;
iii) einen Lokaloszillatoreingang (335, 310) zum Empfangen eines Lokaloszillatorsignals;
iv) einen Mischer (120, 310), der vom Substrat (210) getragen wird und mit dem Hochfrequenzeingang und dem Lokaloszillatoreingang verbunden ist, zur Verwendung bei einer Erzeugung eines Zwischenfrequenzsignals durch Mischen eines empfangenen Hochfrequenzsignals mit dem Lokaloszillatorsignal; und
v) einen Filterkanal (314, 325, 350) zur Verwendung bei einem Steuern einer Passage von Hochfrequenzsignalen in den Detektor und beim Extrahieren des Zwischenfrequenzsignals,
wobei das Substrat (210) mit einer Öffnung (340) versehen ist, deren axiale Richtung sich in das Substrat (210) erstreckt,
**dadurch gekennzeichnet, dass** in der Öffnung (340) ein Zwischenfrequenzextraktionsglied (350, 1210, 1215) des Filterkanals für ein Extrahieren des Zwischenfrequenzsignals aus dem Detektor untergebracht ist, wobei das Zwischenfrequenzextraktionsglied (350, 1210, 1215) ein Koaxialfilter aufweist, dessen physische Abmessungen gewählt sind, um ein Extrahieren des Zwischenfrequenzsignals zu liefern.

2. Detektor nach Anspruch 1, wobei das Substrat (210) erste und zweite gegenüberliegende Flächen aufweist und die Axialrichtung der Öffnung (340) sich von der ersten Fläche zur zweiten erstreckt.

3. Detektor nach Anspruch 2, wobei der Mischer (120, 310) durch die erste gegenüberliegende Fläche des Substrats (210) getragen wird.

4. Detektor nach einem der vorhergehenden Ansprüche, wobei das Koaxialfilter ein Viertelwellenlängenfilter (1210, 1215) aufweist.

5. Detektor nach einem der vorhergehenden Ansprüche, wobei das Koaxialfilter einen generell zylindrischen Abschnitt (1215) der Öffnung (340) und einen Stift (350, 1210) von generell zylindrischem Querschnitt aufweist, wobei der Stift koaxial in dem zylindrischen Abschnitt montiert ist.

6. Detektor nach Anspruch 5, wobei der zylindrische Abschnitt (1215) der Öffnung (340) eine Oberfläche aus elektrisch leitendem Material aufweist und der Stift (350, 1210) ein elektrisch isolierendes Material aufweist, das eine elektrisch leitende Beschichtung auf seiner/seinen zylindrischen Fläche(n) aufweist, wobei diese gemeinsam das Koaxialfilter bereitstellen.

7. Detektor nach einem der Ansprüche 4, 5 oder 6, wobei das Koaxialfilter einen Stift (350, 1210) von generell zylindrischem Querschnitt aufweist, wobei der Stift mindestens zwei Abschnitte (1220, 1225) von jeweils unterschiedlichem Durchmesser aufweist, um das Viertelwellenlängenfilter bereitzustellen.

8. Detektor nach einem der vorhergehenden Ansprüche, der weiter eine hermetische Abdichtung (330) aufweist, welche das Zwischenfrequenzextraktionsglied (350, 1210, 1215) des Filterkanals in der Öffnung (340) dicht abschließt.

9. Detektor nach einem der Ansprüche 5, 6 oder 7, wobei der Stift (350, 1210) in dem zylindrischen Abschnitt (1215) mittels eines ringförmigen Elementes (330) montiert ist, um für eine hermetische Abdichtung der Öffnung (340) zu sorgen.

10. Detektor nach Anspruch 9, wobei der zylindrische Abschnitt (1215) der Öffnung (340) eine gestufte Änderung (1300) des Querschnittes aufweist, um mindestens eine Widerlagerfläche bereitzustellen, gegen welche das ringförmige Element gelagert ist.

11. Detektor für elektromagnetische Strahlung nach einem der vorhergehenden Ansprüche, wobei der Lokaloszillatoreingang (335, 310) ausgebildet ist, um ein Hochfrequenz-Lokaloszillatorsignal zu empfangen, und wobei eine elektrische Verbindung (325) bereitgestellt wird, um das Zwischenfrequenzsignal vom Mischer (120, 310) an das Zwischenfrequenzextraktionsglied (350, 1210, 1215) des Filterkanals zu liefern, wobei diese Verbindung (325) eine Länge (T) aufweist, die so gewählt ist, dass sie eine Fehlanpassung der durch den Filterkanal präsentierten elektrischen Last an eine im Detektor laufende Hochfrequenzstrahlung liefert, derart, dass der Filterkanal zumindest im Wesentlichen einen offenen Kreislauf gegenüber einer Hochfrequenzstrahlung darstellt, , bei Betrieb des Detektors.

12. Detektor nach Anspruch 11, wobei die elektrische Verbindung (325) mit dem Lokaloszillatoreingang (335, 310) verbunden ist.

13. Detektor nach einem der Ansprüche 11 oder 12, wobei der Hochfrequenzeingang (320, 310, 314) und der Lokaloszillatoreingang (335, 310) jeweils mindestens einen elektrischen Leiter aufweisen, und die Länge (X, Y, Z) eines jeden der elektrischen Leiter beträchtlich geringer als die Wellenlänge des Zwischenfrequenzsignals ist, bei Betrieb des Detektors.

14. Detektor nach Anspruch 13, wobei die Länge eines jeden der elektrischen Leiter nicht größer als ein Zehntel der Wellenlänge des Zwischenfrequenzsignals ist, bei Betrieb des Detektors.

15. Detektor nach einem der Ansprüche 13 oder 14, wobei jeder der elektrischen Leiter eine Übertragungsleitung aufweist.

16. Detektor nach einem der Ansprüche 11 bis 15, wobei die elektrische Verbindung (325), welche das Zwischenfrequenzsignal vom Mischer (120, 310) an das Zwischenfrequenzextraktionsglied des Filterkanals liefert, mindestens einen Draht aufweist.

17. Detektor nach einem der vorhergehenden Ansprüche, wobei der Mischer (120, 310) einen subharmonischen Mischer aufweist.

18. Detektor nach einem der vorhergehenden Ansprüche, wobei der Mischer (120, 310) ein Paar von abgeglichenen Dioden aufweist.

19. Detektor nach einem der vorhergehenden Ansprüche, wobei der Lokaloszillatoreingang (335, 310) und/oder der Hochfrequenzeingang (320, 310, 314) zumindest teilweise als eine Übertragungsleitung, wie beispielsweise ein Mikrostrip, aufgebaut sind.

20. Detektor nach Anspruch 19, wobei entweder einer oder beide, und zwar von dem Eingang (320, 310, 314) zum Empfangen eines Erfassungssignals für elektromagnetische Strahlung und dem Eingang (335, 310) für ein Lokaloszillatorsignal, durch Mikrostrip- oder Streifenleitungs-Schaltkreise bereitgestellt werden, die eine Antenne (320, 335), eine Verbindung zum Mischer (120, 310) und ein Hochfrequenzfilter (314) beinhalten.

21. Detektor nach einem der vorhergehenden Ansprüche, wobei der Mischer (120, 310) mit dem Lokaloszillatoreingang (335, 310) und dem Hochfrequenzeingang (320, 310, 314) durch jeweilige Übertragungsleitungen verbunden ist und der Detektor weiter eine Abstimm-Stichleitung (355) aufweist, die mit der Übertragungsleitung des Hochfrequenzeingangs (320, 310, 314) verbunden ist, wobei die Längen (X, S) der Abstimm-Stichleitung und der Übertragungsleitung in Kombination so gewählt sind, dass eine Kopplung des Lokaloszillatorsignals an den Mischer (120, 310), in Betrieb, optimiert wird, und die Länge der Abstimm-Stichleitung (S) gewählt so ist, dass sie eine virtuelle Zwischenimpedanz gegenüber dem empfangenen Hochfrequenzsignal darstellt.

22. Detektor nach den Ansprüchen 20 und 21, wobei die Länge "Y" eines Mikrostrip-Abschnittes zwischen dem Mischer (120, 310) und dem Hochfrequenzfilter (314) so gewählt ist, dass eine optimale Kopplung an den Mischer (120, 310) auf der Frequenz des empfangenen Hochfrequenzsignals geliefert wird.

23. Detektor nach einem der vorhergehenden Ansprüche, wobei das Zwischenfrequenzextraktionsglied (350, 1210, 1215) einen Filteraufbau aufweist, der ein Frequenzdurchlassband von 0,1 GHz bis 60 GHz aufweist.

24. Terahertz-Strahlungskamera, die einen Detektor nach einem der vorhergehenden Ansprüche aufweist.

## Revendications

1. Détecteur de radiation électromagnétique comprenant .
i) au moins un substrat (210) ;
ii) une entrée de radiofréquence (320, 310, 314) pour recevoir des signaux de radiofréquence à détecter ;
(iii) une entrée d'oscillateur local (335, 310) pour recevoir un signal d'oscillateur local ;
iv) un mélangeur (120, 310) supporté par le substrat (210) et couplé à l'entrée de radiofréquence et à l'entrée d'oscillateur local pour l'utilisation dans la génération d'un signal de fréquence intermédiaire en mélangeant un signal de radiofréquence reçu avec le signal d'oscillateur local ; et
v) un canal de filtre (314, 325, 350) pour utilisation dans la commande du passage de signaux de radiofréquence dans le détecteur et dans l'extraction du signal de fréquence intermédiaire,
où le substrat (210) est muni d'une ouverture (340) ayant une direction axiale qui s'étend dans le substrat (210),
**caractérisé en ce que** l'ouverture (340) loge une section d'extraction de fréquence intermédiaire (350, 1210, 1215) du canal de filtre pour extraire le signal de fréquence intermédiaire du détecteur, la section d'extraction de fréquence intermédiaire (350, 1210, 1215) comprenant un filtre coaxial ayant des dimensions physiques sélectionnées pour permettre l'extraction du signal de fréquence intermédiaire.

2. Détecteur selon la revendication 1, dans lequel le substrat (210) a des première et deuxième surfaces opposées, et la direction axiale de l'ouverture (340) s'étend de la première surface à la seconde.

3. Détecteur selon la revendication 2, dans lequel le mélangeur (120, 310) est supporté par ladite première surface opposée du substrat (210).

4. Détecteur selon l'une quelconque des revendications précédentes, dans lequel ledit filtre coaxial comprend un filtre d'un quart de longueur d'onde (1210, 1215).

5. Détecteur selon l'une quelconque des revendications précédentes, dans lequel le filtre coaxial comprend une section généralement cylindrique (1215) de l'ouverture (340) et un axe (350, 1210) d'une section transversale généralement cylindrique, l'axe étant installé d'une manière coaxiale dans ladite section cylindrique.

6. Détecteur selon la revendication 5, dans lequel la section cylindrique (1215) de l'ouverture (340) possède une surface en un matériau électriquement conducteur, et l'axe (350, 1210) comprend un matériau électriquement isolant ayant un revêtement électriquement conducteur sur sa ou ses surfaces cylindriques, celles-ci réalisant ensemble ledit filtre coaxial.

7. Détecteur selon l'une quelconque des revendications 4, 5 ou 6, dans lequel le filtre coaxial comprend un axe (350, 1210) d'une section transversale généralement cylindrique, l'axe ayant au moins deux sections (1220, 1225) de diamètres respectifs différents pour réaliser ledit filtre de quart de longueur d'onde.

8. Détecteur selon l'une quelconque des revendications précédentes, comprenant en outre un joint hermétique (330), rendant étanche ladite section d'extraction de fréquence intermédiaire (350, 1210, 1215) du canal de filtre dans l'ouverture (340).

9. Détecteur selon l'une quelconque des revendications 5, 6 ou 7, dans lequel l'axe (350, 1210,) est monté dans ladite section cylindrique (1215) au moyen d'un élément annulaire (330) pour réaliser un joint hermétique à l'ouverture (340).

10. Détecteur selon la revendication 9, dans lequel ladite section cylindrique (1215) de l'ouverture (340) possède un changement de pas (1300) en section transversale pour réaliser au moins une surface de butée contre laquelle ledit élément annulaire est logé.

11. Détecteur de radiation électromagnétique selon l'une quelconque des revendications précédentes, dans lequel l'entrée d'oscillateur local (335, 310) est apte à recevoir un signal d'oscillateur local de radiofréquence, et où il est réalisé une connexion électrique (325) pour délivrer le signal de fréquence intermédiaire du mélangeur (120, 310) à la section d'extraction de fréquence intermédiaire (350, 1210, 1215) du canal de filtre, ladite connexion (325) a une longueur (T) sélectionnée pour décaler la charge électrique présentée par le canal de filtre à la radiation de radiofréquence passant dans le détecteur de telle sorte que le canal de filtre présente au moins sensiblement un circuit ouvert à la radiation de radiofréquence en cours d'utilisation du détecteur.

12. Détecteur selon la revendication 11, dans lequel ladite connexion électrique (325) est connectée à l'entrée de l'oscillateur local (335, 310).

13. Détecteur selon l'une quelconque des revendications 11 ou 12, dans lequel l'entrée de radiofréquence (320, 310, 314) et l'entrée de l'oscillateur local (335, 310) comprennent chacune au moins un conducteur électrique, et la longueur (X, Y, Z) de chacun desdits conducteurs électriques est nettement plus petite que la longueur d'onde du signal de fréquence intermédiaire, en cours d'utilisation du détecteur.

14. Détecteur selon la revendication 13, dans lequel la longueur de chacun desdits conducteurs électriques n'est pas supérieure à un dixième de la longueur d'onde du signal de fréquence intermédiaire, en cours d'utilisation du détecteur.

15. Détecteur selon l'une quelconque des revendications 13 ou 14, dans lequel chacun des conducteurs électriques comprend une ligne de transmission.

16. Détecteur selon l'une quelconque des revendications 11 à 15, dans lequel la connexion électrique (325) pour la délivrance du signal de fréquence intermédiaire du mélangeur (120, 310) à la section d'extraction de fréquence intermédiaire du canal de filtre comprend au moins un câble.

17. Détecteur selon l'une quelconque des revendications précédentes, dans lequel le mélangeur (120, 310) comprend un mélangeur de subharmoniques.

18. Détecteur selon l'une quelconque des revendications précédentes, dans lequel le mélangeur (120, 310) comprend une paire de diodes équilibrées.

19. Détecteur selon l'une quelconque des revendications précédentes, dans lequel l'entrée de l'oscillateur local (335, 310) et/ou l'entrée de radiofréquence (320, 310, 314) sont construites au moins partiellement comme une ligne de transmission, comme une microbande.

20. Détecteur selon la revendication 19, dans lequel l'une quelconque ou les deux parmi l'entrée (320, 310, 314) pour recevoir un signal de détection de radiation électromagnétique et l'entrée (335, 310) pour un signal d'oscillateur local sont réalisées par un circuit de microbande ou de stripline incorporant une antenne (320, 335), une connexion au mélangeur (120, 310) et un filtre de radiofréquence (314).

21. Détecteur selon l'une quelconque des revendications précédentes, dans lequel le mélangeur (120, 310) est couplé à l'entrée de l'oscillateur local (335, 310) et à l'entrée de radiofréquence (320, 310, 314) par des lignes de transmission respectives, et le détecteur comprend en outre un syntoniseur talon (355) connecté à la ligne de transmission de l'entrée de radiofréquence (320, 310, 314), les longueurs (X, S) du syntoniseur talon et de ladite ligne de transmission en combinaison étant sélectionnées pour optimiser le couplage du signal d'oscillateur local au mélangeur (120, 310) en cours d'utilisation, et la longueur du syntoniseur talon (S) étant sélectionnée pour présenter une impédance virtuelle intermédiaire au signal de radiofréquence reçu.

22. Détecteur selon les revendications 20 et 21, dans lequel la longueur "Y" d'une section de microbande entre le mélangeur (120, 310) et le filtre de radiofréquence (314) est sélectionnée pour permettre un couplage optimal au mélangeur (120, 310) à la fréquence du signal de radiofréquence reçu.

23. Détecteur selon l'une quelconque des revendications précédentes, dans lequel la section d'extraction de fréquence intermédiaire (350, 1210, 1215) comprend une construction de filtre ayant une bande passante de fréquence de 0,1 GHz à 60 GHz.

24. Caméra de radiation tera-hertz comprenant un détecteur selon l'une quelconque des revendications précédentes.
